# EUROPÄISCHE PATENTSCHRIFT

(11) **EP 0 720 060 B1**
(45) Veröffentlichungstag und Bekanntmachung des Hinweises auf die Patenterteilung: **25.03.1998**
(21) Anmeldenummer: 95119851.4
(22) Anmeldetag: 15.12.1995
(51) Int. Cl.: G03F 7/32, G03G 13/28

(54) **Verfahren zum Entwickeln bestrahlter strahlungsempfindlicher Aufzeichnungsmaterialien**
Process for the development of irradiated radiation-sensitive recording materials
Procédé pour développer des matériaux d'enregistrement sensibles aux rayonnements exposés

(30) Priorität: 21.12.1994 DE 4445820
(43) Veröffentlichungstag der Anmeldung: 03.07.1996
(73) Patentinhaber: Agfa-Gevaert AG, 51373 Leverkusen (DE)
(72) Erfinder: Elsässer, Andreas, Dr., D-65510 Idstein (DE); Frass, Werner, Dr., D-65207 Wiesbaden (DE); Bachstein, Jutta, D-65199 Wiesbaden (DE)

(56) Entgegenhaltungen:
- EP-A- 0 513 948
- DE-A- 3 315 395
- DE-A- 4 035 953

## Beschreibung

Die Erfindung betrifft ein Verfahren zum Entwickeln bestrahlter, strahlungsempfindlicher Aufzeichnungsmaterialien mit einem wäßrig-alkalischen Entwickler, der spezielle Verbindungen enthält.

Ein wäßrig-alkalischer Entwickler für strahlungsempfindliche Aufzeichnungsmaterialien, insbesondere solchen, aus denen Offsetdruckplatten hergestellt werden, muß eine Reihe von Forderungen erfüllen. Er soll ergiebig sein. Das bedeutet, die Entwicklungsleistung soll auch nach längerem Gebrauch und dadurch gestiegener Belastung durch abgelöste Schichtbestandteile möglichst wenig abnehmen. Die sogenannte "Tongrenze", bei der der Entwickler verbraucht ist und die Schicht an den sogenannten Nichtbildstellen nur noch unvollständig ablöst, soll möglichst hoch liegen. Selbstverständlich soll er die Aufzeichnungsmaterialien möglichst schnell und vollständig entwickeln. Dies ist besonders wichtig bei der maschinellen Herstellung der Druckplatten in Verarbeitüngsstraßen. Bedingt durch kurze Taktzeiten kann eine Entwicklungsdauer von deutlich weniger als 30 s notwendig sein.

Die Bereiche des Aufzeichnungsmaterials, die später die Druckfarbe annehmen (die sogenannten Bildstellen), sollen vom Entwickler möglichst wenig angegriffen werden. Nur dann ist gewährleistet, daß auch nach mehrmaligem Entwickeln, wie es beispielsweise beim Photocomposing möglich ist, keine Bildschädigung eintritt.

Beim Entwickeln sollen sich weder Schaum noch feste Niederschläge bilden. Letztere könnten die Entwicklungsgeräte verunreinigen und damit einen erhöhten Wartungsaufwand erforderlich machen oder sich gar auf dem entwickelten Aufzeichnungsmaterial absetzen.

Die Entwicklung soll zudem eine harte Gradation zulassen. Nur dann werden die Bildpunkte exakt von der Filmvorlage auf die Platte übertragen, wobei auch kleine Rasterpunkte einwandfrei wiedergegeben werden.

Aus ökologischen und ökonomischen Gründen ist es von Vorteil, wenn der Entwickler in Form eines flüssigen oder festen Konzentrats angeboten werden kann, das erst der Verbraucher mit Wasser verdünnt. Die Härte des Wassers ist regional verschieden, was aber die Eigenschaften des gebrauchsfertigen Entwicklers nicht beeinflussen soll. Daraus ergibt sich die Forderung nach einer geringen Empfindlichkeit gegen Wasserhärte.

Schließlich darf auch der Träger des Aufzeichnungsmaterials durch den Entwickler nicht angegriffen werden. Bei dem häufig für Druckplatten verwendeten Aluminiumträgermaterial soll insbesondere die Aluminiumoxidschicht beim Entwickeln intakt bleiben.

Mit den bisher bekannten Entwicklern ließen sich die genannten Forderungen nicht alle gleichzeitig erfüllen. Besonders die aus Konzentraten hergestellten Entwickler zeigten unbefriedigende Eigenschaften.

Überaus empfindlich gegen Wasserhärte sind die Entwickler, die als alkalisch reagierende Bestandteile Amine, Hydroxide, Phosphate, Silikate, Borate und Carbonate enthalten. Es wurde daher versucht, diesen Nachteil durch den Zusatz von Ethylendiamintetraessigsäure, Diethylentriaminpentaessigsäure oder Nitrilotriessigsäure bzw. der Salze dieser Verbindungen zu vermeiden. Die so veränderten Entwickler griffen wiederum den Träger stärker an. Auch der Zusatz von Di-, Tri- oder Polyphosphaten war nicht geeignet, die Abhängigkeit von der Wasserhärte zu reduzieren, da diese Verbindungen in den alkalischen Entwicklern hydrolysiert wurden.

In der DE-A 33 15 395 ist ein Konzentrat beschrieben, das ein Alkalisilikat und einen Chelatbildner enthält. Durch Verdünnen mit Leitungswasser wird daraus ein Entwickler für Aufzeichnungsmaterialien mit einem ortho-Chinondiazid in der lichtempfindlichen Schicht. Der Chelatbildner verhindert, daß die im Leitungswasser enthaltenen Calcium- und Magnesiumionen mit dem Alkalisilikat unter Bildung von unlöslichem Material reagieren. Als Chelatbildner sind organische Phosphonsäuren und Phosphonotricarbonsäuren, wie Aminotrismethylenphosphonsäure oder Ethylendiamintetramethylenphosphonsäure, bevorzugt. Diese Chelatbildner sind jedoch biologisch nicht abbaubar.

Es bestand daher die Aufgabe, ein Verfahren zum Entwickeln strahlungsempfindlicher Aufzeichnungsmaterialien zur Verfügung zu stellen, bei dem die oben beschriebenen Nachteile nicht mehr auftreten.

Überraschenderweise ließ sich diese Aufgabe lösen durch die Verwendung von Verbindungen, die eigentlich Bestandteile von Wasch- und Reinigungsmitteln sind. Gegenstand der vorliegenden Erfindung ist deshalb ein Verfahren zum Entwickeln bestrahlter, strahlungsempfindlicher Aufzeichnungsmaterialien mit einem Entwickler, der mindestens eine in wäßriger Lösung alkalisch reagierende Verbindung enthält, dadurch gekennzeichnet, daß dem Entwickler mindestens eine Verbindung gemäß Formel I 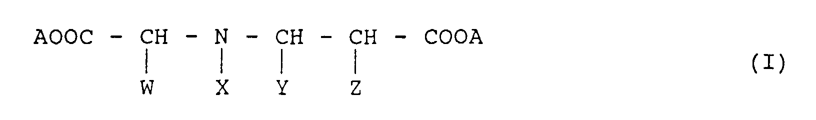 zugesetzt wird, worin
- A: H, Na, K, NH₄ oder NR₄ ist, wobei
- R: ein. gegebenenfalls substituierter Alkyl-Rest ist,
- W und X: unabhängig voneinander H oder -CH₂-COOA sind,
- Y: H oder COOA und
- Z: H oder OH ist,
mit der Maßgabe, daß die Verbindung der Formel I mindestens 3 COOA-Einheiten aufweist.

Alle Verbindungen der Formel I sind biologisch abbaubar. Die alkalisch reagierende Verbindung ist bevorzugt ein Amin, Hydroxid, Silikat, Phosphat, Borat oder Carbonat. Bevorzugte Amine sind Ethyl-, Diethyl- und Triethylamin, Ethanolamin, Di- und Triethanolamin, Ethylendiamin und Morpholin. Bevorzugte Hydroxide sind (C₁-C₁₀)Alkylammoniumhydroxide sowie Di-, Tri- und Tetra(C₁-C₁₀)alkylammoniumhydroxide. Bevorzugte Silikate sind Natrium-, Kalium- und Ammoniumsilikate sowie die entsprechenden Di-, Tri- und Polysilikate. Bevorzugte Phosphate bzw. Borate sind Natrium-, Kalium- und Ammonium-phosphate bzw. -hydrogenphosphate und -dihydrogenphosphate sowie die entsprechenden Ortho und Tetraborate. Bevorzugte Carbonate sind Natrium-, Kalium- und Ammoniumcarbonate- bzw. -hydrogencarbonate. Von allen alkalisch reagierenden Verbindungen sind die Alkalisilikate am besten geeignet.

Der Anteil der alkalisch reagierenden Verbindung(en) ist auf die Art des Aufzeichnungsmaterials abzustimmen. Er liegt in der Regel bei 0,1 bis 20 Gew.-%, bevorzugt 0,5 bis 10 Gew.-%, jeweils bezogen auf das Gesamtgewicht des gebrauchsfertigen Entwicklers. Bei den festen oder flüssigen Konzentraten liegt der Anteil entsprechend höher.

In den Verbindungen der Formel I ist A bevorzugt H oder Na. Im Fall X = CH₂-COOA ist bevorzugt W = Y = H. Ist andererseits X = H, dann ist bevorzugt W = CH₂-COOA und Y = COOA. Der gegebenenfalls substituierte Alkylrest R ist bevorzugt ein geradkettiger oder verzweigter (C₁-C₂₀)Alkylrest, der gegebenenfalls mit Hydroxy-, (C₁-C₆)Alkoxy-, (C₂-C₂₀)alkanoyloxy- oder (C₆-C₁₀)Arylgruppen substituiert ist. Der Anteil der Verbindung(en) der Formel I richtet sich nach der Art des zu verarbeitenden Aufzeichnungsmaterials. Allgemein beträgt er 0,01 bis 5 Gew.-%, bevorzugt 0,1 bis 5 Gew.-%, jeweils bezogen auf das Gesamtgewicht des gebrauchsfertigen Entwicklers.

Gegenstand der vorliegenden Erfindung ist auch ein Entwickler, der im wesentlichen aus Wasser, mindestens einer Verbindung der Formel I, mindestens einer alkalischen Verbindung sowie gegebenenfalls einem organischen Lösemittel, das mit Wasser mischbar ist, Tensiden, Korrosionsinhibitoren, O-Carboxymethyl- oder O,O'-Bis-carboxymethyl-polyethylenglykol mit 2 bis 500 Ethylenglykoleinheiten, und/oder Antischaummitteln besteht.

Als "mischbar mit Wasser" wird ein organisches Lösemittel bezeichnet, das in der verwendeten Menge (bis zu 20 Gew.-%) bei einer Temperatur, bei der Entwickler normalerweise gelagert oder verwendet werden (etwa 0 bis 60 °C), mit Wasser eine einheitliche Lösung bildet.

Bevorzugte Verbindungen der Formel I sind N,N-Bis-carboxymethyl-β-alanin, N,N-Bis-carboxymethyl-isoserin, N-(1,2-Dicarboxy-ethyl)-3-hydroxy-asparaginsäure, 2,2'-Iminodibernsteinsäure sowie deren Natrium-, Kalium-, Ammonium- oder quaternäre Ammoniumsalze.

Gemische, die Verbindungen der Formel I enthalten, gehören bereits zum Stand der Technik. So ist in der EP-A 0 356 974 ein Waschmittel beschrieben, das als Enthärter 2 bis 25 Gew.-% an β-Alanin-N,N-diessigsäure [= N,N-Bis-carboxymethyl-β-alanin; Formel I, A = W = Y = Z = H, X = CH₂-COOA] enthält.

Ein Reinigungsmittel, das ein organisches Lösemittel mit einem Siedepunkt von etwa 90 °C und N-(3-Hydroxysuccinyl)-asparaginsäure (= N-(1,2-Dicarboxy-ethyl)-3-hydroxy-asparaginsäure; Formel I, A = X = H, W = CH₂-COOA, Y = COOA, Z = OH), β-Alanin-N,N-diessigsäure oder Iminodibernsteinsäure (Formel I, A = X = Z = H, W = CH₂-COOA, Y = COOA) enthält, ist in der EP-A 0 513 948 offenbart.

In dem Waschmittel gemäß der EP-A 0 509 382 dienen die drei letztgenannten Verbindungen als Stabilisatoren für das darin ebenfalls enthaltene Bleichmittel. In der EP-A 0 504 091 ist schließlich ein phosphatfreies Geschirrspülmittel genannt. Es umfaßt Isoserin-N,N-diessigsäure (= N,N-Bis-carboxymethyl-isoserin; Formel I, A = W = Y = H, Z = OH, X = CH₂-COOA). Isoserin-N,N-diessigsäure ist, zusammen mit einem anionischen oder nichtionischen oberflächenaktiven Mittel und einem organischen Lösemittel, auch in dem Reinigungsmittel gemäß der EP-A 0 511 091 enthalten.

Die in den vorgenannten Reinigungsmitteln enthaltenen Zusätze, z. B. Bleichmittel, machen diese Lösungen für Entwickler jedoch völlig unbrauchbar.

Je nach Art der zu verarbeitenden Aufzeichnungsmaterialien kann der im erfindungsgemäßen Verfahren verwendete Entwickler weitere Additive enthalten. Sollen sehr kurze Entwicklungszeiten erreicht werden, dann ist der Zusatz von wasserlöslichen organischen Lösemitteln, wie Alkoholen, speziell Glykolether, nützlich. Gleiches gilt bei der Entwicklung negativ arbeitender und elektrophotographischer Aufzeichnungsmaterialien. Ein lösemittelhaltiger Entwickler greift die Bildstellen jedoch stärker an. Der Anteil an organischem Lösemittel muß daher sorgfältig optimiert werden. Allgemein liegt er unter 20 Gew.-%, bezogen auf das Gesamtgewicht des gebrauchsfertigen Entwicklers. Weiterhin kann der Entwickler eine oder mehrere oberflächenaktive Verbindung(en) zur Einstellung einer bestimmten Oberflächenspannung enthalten. Insbesondere bei Sprühantrag ist eine Oberflächenspannung von weniger als 50 mN/m vorteilhaft, um eine rasche Benetzung der Kopierschicht zu gewährleisten. Grundsätzlich sind dafür kationische und anionische, aber auch zwitterionische und nichtionische Tenside oder Tensidkombinationen geeignet.

Bei Aufzeichnungsmaterialien, deren Träger besonders empfindlich gegen alkalische Entwickler sind, wie anodisierte Aluminiumfolie, ist die Zugabe von Korrosionsinhibitoren vorteilhaft. Hierfür haben sich insbesondere ionisierbare Verbindungen von Elementen der 2. oder 3. Hauptgruppe sowie der 3. Nebengruppe des Periodensystems bewährt. Besonders bevorzugt sind Hydroxide, Halogenide, Sulfate, Nitrate, Acetate, Lactate, Lävulinate, Malonate oder Fumarate des Calciums, Strontiums oder Bariums. Gleichfalls geeignet sind: Lithiumhydroxid, -chlorid, -bromid, -nitrat, -carbonat oder -sulfat.

Enthält der Entwickler (oder die strahlungsempfindliche Schicht) Additive, die während der Entwicklung Niederschläge bilden können, sollten hydrotrope Substanzen, wie Arylsulfonate, -carboxylate oder Phosphatester, zugefügt werden. Schaum- und Fladenbildung verhindert auch die Zugabe von O-Carboxymethyl- oder O,O'-Bis-carboxymethyl-polyethylenglykol mit 2 bis 500 Ethylenglykol-Einheiten. Sind größere Mengen an Tensiden im Entwickler enthalten, so wird dem Entwickler zweckmäßig noch ein Antischaummittel zugesetzt.

Das erfindungsgemäße Verfahren eignet sich für eine Reihe von Aufzeichnungsmaterialien. Entsprechend der Art der strahlungsempfindlichen oder photoleitfähigen Schicht können sie eingeteilt werden in
1. solche mit einer positiv oder negativ arbeitenden Schicht auf Basis von Diazoverbindungen,
2. solche mit einer positiv oder negativ arbeitenden Schicht, die Verbindungen enthält, die unter der Einwirkung aktinischer Strahlung Säure produzieren und Verbindungen, die durch die Säure gespalten werden,
3. solche mit einer negativ arbeitenden Schicht, die polymerisierbare, olefinisch ungesättigte Verbindungen und Photopolymerisationsinitiatoren enthält, und
4. solche mit einer positiv arbeitenden Schicht, die Photohalbleiter oder ein Gemisch von Photohalbleitern und Sensibilisatoren enthält.

In den genannten strahlungsempfindlichen oder photoleitfähigen Schichten ist im allgemeinen auch ein in wäßrig-alkalischer Lösung lösliches, filmbildendes Polymer als Bindemittel enthalten. Es besitzt funktionelle Gruppen, bevorzugt -COOH, -SO₃H, -PO(OH)₂, -SH, -OH und -NH₂. Hierzu zählen insbesondere Polykondensate von Phenolen mit Aldehyden, speziell Novolakharze. Der Gehalt an phenolischen Hydroxygruppen beträgt bevorzugt etwa 2 bis 9 mmol pro Gramm des Bindemittels. Daneben sind auch Homo- oder Copolymere des ortho-, meta- oder para-Hydroxystyrols geeignet. Die Hydroxystyrol-Einheiten können noch weiter substituiert sein, insbesondere mit Alkyl- oder Alkoxygruppen. Verwendbar sind auch Homo- oder Copolymere mit Einheiten aus Acrylsäure- bzw. Methacrylsäuredihydroxyphenylester oder -trihydroxyphenylester, N-Dihydroxyphenyl- oder N-Trihydroxyphenyl-acrylamid bzw. -methacrylamid. Die weiteren Einheiten in den Copolymeren sind beispielsweise Einheiten aus Styrol, α-Methyl-styrol, Brom- oder Chlorstyrol, (C₁-C₄)alkyl-vinyl-ether, Acrylnitril, Vinylacetat und/oder Maleinsäureanhydrid. Als Bindemittel sind auch Homo- und Copolymere mit Einheiten aus N-Hydroxyphenyl- oder N-Acetoxyphenyl-maleimid geeignet. Als Comonomere kommen hier insbesondere Hydroxy- und Acetoxystyrol in Frage. Schließlich lassen sich auch 1:1-Copolymere aus Maleimid und Alkyl-vinyl-ethern verwenden. Gut geeignet sind auch Homo- oder Copolymere mit Hydroxystyrol-Einheiten, die mit Alkan- oder Cycloalkansulfonylisocyanaten umgesetzt wurden. Diese Polymere enthalten entsprechend Sulfonylurethangruppen der Formel -O-CO-NH-SO₂-R, wobei R für Alkyl oder Cycloalkyl steht. Die 1:1-Copolymere wie auch die Polymere mit den Sulfonylurethangruppen enthalten N-H acide Gruppen.

Die positiv arbeitende Schicht vom Typ 1 enthält in der Regel 1,2-Chinondiazide, bevorzugt Ester und Amide von 1,2-Naphthochinondiazidsulfonsäuren, besonders bevorzugt Ester aus 1,2-Naphthochinon-2-diazid-4- oder -5-sulfonsäure und Polyhydroxyaromaten, wie Dihydroxy- oder Trihydroxybenzophenon. Die bestrahlten Bereiche sind in dem wäßrig-alkalischen Entwickler löslich, so daß ein positives Bild zurückbleibt. Aus der normalerweise positiv arbeitenden Schicht kann durch zusätzliche Verfahrensschritte auch ein negatives Bild erhalten werden. Für ein solches Umkehrverfahren eignen sich besonders Schichten, die 1,2-Naphthochinon-2-diazid-4-sulfonsäureester enthalten. Verbindungen, wie 2-Diethylamino-4,6-diethoxy-[1,3,5]triazin erhöhen den Spielraum bei der thermischen Nachbehandlung. Auch Umsetzungsprodukte von monofunktionellen Alkoholen, wie Ethylenglykol-monoalkylether, mit monofunktionellen Isocyanaten, wie Phenylisocyanat, erhöhen den Bildumkehrspielraum. Sie bewirken ferner, daß die Bildbereiche nach der Konvertierung weniger vom Entwickler angegriffen werden. Die negativ arbeitende Schicht vom Typ 1 enthält beispielsweise Kondensationsprodukte von Diphenylamin-4-Diazoniumsalzen mit Aldehyden, bevorzugt Formaldehyd, oder Polymere mit seitenständigen Diazoniumeinheiten (US-A 4 581 313).

Die säurebildende Verbindung in der positiv arbeitenden Schicht vom Typ 2 ist bevorzugt ein Phosphonium-, Sulfonium-, Jodonium- oder Diazoniumsalz, ein 1,2-Chinondiazid, eine Organometall/Organohalogen-Kombination oder eine organische Halogenverbindung, besonders bevorzugt ein halogenmethylsubstituiertes [1,3,5]Triazin. Bevorzugt sind solche Phosphonium-, Sulfonium- und Iodoniumsalze, die in organischen Lösemitteln löslich sind. Das trifft speziell auf die Hexafluorophosphate und Tetrafluoroborate zu. Grundsätzlich sind alle auch als Radikalstarter bekannten organischen Halogenverbindungen, die bei Bestrahlung Halogenwasserstoffsäure bilden, geeignet. Dies sind bevorzugt solche, in denen mindestens ein Halogenatom gebunden ist an ein Kohlenstoffatom, das Teil einer aliphatischen Kette oder eines aromatischen Rings ist. Zu diesen Verbindungen zählen s-Triazine, die mit Halogenmethylgruppen, insbesondere Trichlormethylgruppen, und mit einem aromatischen bzw. ungesättigten Rest substituiert sind. Ebenso geeignet sind 2-Trichlormethyl-[1,3,4]oxadiazole. Die spektrale Empfindlichkeit der sogenannten Photosäuregeneratoren kann durch dem Fachmann bekannte Sensibilisatoren beeinflußt werden.

Als säurespaltbare Verbindungen in der Schicht vom Typ 2 haben sich vor allem folgende Verbindungsklassen bewährt:
a) solche mit mindestens einer Orthocarbonsäureester- und bzw. oder Carbonsäureamidacetalgruppe, wobei die Verbindungen auch polymeren Charakter haben und die genannten Gruppen in der Hauptkette oder seitenständig auftreten können,
b) oligomere oder polymere Verbindungen mit wiederkehrenden Acetal- und/oder Ketalgruppen in der Hauptkette,
c) Verbindungen mit mindestens einer Enolether- oder N-Acyliminocarbonatgruppe,
d) cyclische Acetale oder Ketale von β-Ketoestern oder -amiden,
e) Verbindungen mit Silylethergruppen,
f) Verbindungen mit Silylenolethergruppen,
g) Monoacetale bzw. Monoketale von Aldehyden bzw. Ketonen, deren Löslichkeit im Entwickler zwischen 0,1 und 100 g/l beträgt,
h) Ether auf der Basis tertiärer Alkohole,
i) Carbonsäureester und Carbonate, deren Alkoholkomponente ein tertiärer Alkohol, ein Allylalkohol oder ein Benzylalkohol ist, und
j) N,O-Polyacetale.

Es können auch Mischungen der vorgenannten säurespaltbaren Komponenten eingesetzt werden.

Auch aus der Schicht vom Typ 2 kann durch zusätzliche Verfahrensschritte ein negatives Bild erhalten werden. Dazu wird das bestrahlte Aufzeichnungsmaterial vor dem Entwickeln noch erhitzt und dann ganzflächig bestrahlt.

Die negativ arbeitende Schicht vom Typ 3 enthält bevorzugt eine Kombination aus einem ethylenisch ungesättigten Monomer, insbesondere einem Acryl- oder Methacrylsäureester eines mehrwertigen Alkohols, und einem Photoinitiator oder eine Kombination aus einer Verbindung, die in Gegenwart von Säure zur Polyaddition befähigt ist, beispielsweise einer Epoxyverbindung, und einer Verbindung, die bei Bestrahlung starke Säure bildet. In diesen Schichten werden als alkalilösliche Bindemittel bevorzugt Polykondensate oder Polymere mit seitenständigen Carboxygruppen verwendet. Als Bindemittel können in den negativ arbeitenden Gemischen im Prinzip dieselben Harze eingesetzt werden wie oben beschrieben, bevorzugt werden jedoch Harze mit seitenständigen Carboxylgruppen.

Unter "Entwickeln" versteht der Fachmann bei elektrophotographischen Aufzeichnungsmaterialien (diese enthalten eine Schicht des oben genannten Typs 4) das Sichtbarmachen des durch Bestrahlen hergestellten elektrostatischen Ladungsbildes durch Aufbringen eines (trockenen) Tonerpulvers. Die Tonerpartikel werden dann durch Einbrennen fixiert. Das nachfolgende Entfernen der nicht-betonerten Bereiche der Schicht wird zur Unterscheidung davon als "Entschichten" bezeichnet. Der Einfachheit halber wird in der vorliegenden Erfindung stets nur von "Entwickler(lösungen)" gesprochen, gemeint sind aber ebenso auch "Entschichter(lösungen)".

Elektrophotographische Schichten vom Typ 4 sind beispielsweise in der EP-A 0 157 241 und der EP-A 0 324 180 beschrieben. Als alkalilösliche Bindemittel enthalten diese Schichten bevorzugt Polymere oder Polykondensate mit seitenständigen Carboxy- oder phenolischen Hydroxygruppen.

Alle Schichten vom Typ 1 bis 4 können für spezielle Erfordernisse, wie Flexibilität, Haftung und Glanz, außerdem noch Substanzen wie Polyglykole, Celluloseether (z. B. Ethylcellulose) oder Netzmittel zugesetzt werden. Schließlich können sie noch Farbstoffe oder feinteilig dispergierte Pigmente enthalten.

Als Trägermaterial für Schichtdicken unter ca. 10 µm werden meist Metalle verwendet. Für Offsetdruckplatten wird gewöhnlich walzblankes, mechanisch und/oder elektrochemisch aufgerauhtes und gegebenenfalls anodisiertes Aluminium eingesetzt, das zudem noch chemisch (z. B. mit Polyvinylphosphonsäure, Silikaten, Phosphaten oder Hexafluorzirkonaten) vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag.

Nach dem Auftragen der Schicht wird das Aufzeichnungsmaterial je nach Schichttyp bildmäßig und gegebenenfalls vollflächig bestrahlt. Übliche Strahlungsquellen sind anwendungsbedingt z. B. Röhrenlampen, Xenonimpulslampen, metallhalogeniddotierte Quecksilberdampf-Hochdrucklampen und Kohlebogenlampen. In automatischen Verarbeitungsanlagen bevorzugt man Laser, wie Argon- oder Krypton-Ionen-Laser. Auch Elektronen- oder Röntgenstrahlung kann zur Bilderzeugung verwendet werden.

Die anschließende Entwicklung mit den vorgenannten Lösungen erfolgt bevorzugt in Sprüh-, Stau- oder Tauchbad-Entwicklungsgeräten bei Temperaturen von 18 bis 50 °C, bevorzugt 20 bis 40 °C. Die Entwicklungsdauer beträgt allgemein 5 s bis 1 min.

An diese Entwicklung können sich weitere Verarbeitungsschritte anschließen. Beispielsweise können Druckplatten mit einer (sauren) Hydrophilierungslösung behandelt oder mit einer Konservierungsschicht versehen werden. Zur Erhöhung der Widerstandsfähigkeit beim Druck sowie der Resistenz gegen Auswaschmittel, Korrekturmittel und UV-härtbare Druckfarben können die entwickelten Platten kurzzeitig erhitzt werden. Vor dem Erhitzen können auch sogenannte Einbrenngummierungen aufgetragen werden.

Bevorzugte Ausführungsformen sind in den folgenden Beispielen angegeben. Gt bedeutet Gewichtsteil(e) und Vergleichsbeispiele sind mit * gekennzeichnet.

### Herstellung strahlungsempfindlicher Aufzeichnungsmaterialien

Auf wie jeweils angegeben aufgerauhte, in Schwefelsäure anodisierte und schließlich mit Polyvinylphosphonsäure hydrophilierte Aluminiumfolien wurden die nachfolgend beschriebenen Beschichtungslösungen aufgebracht. Zusätzlich erhielten die mit den Lösungen 3 und 6 beschichteten Materialien eine nicht lichtempfindliche Deckschicht von 2,0 µm aus Polyvinylalkohol (K-Wert 4, Restacetylgruppengehalt 12 %), dem 3 Gew.-% (bezogen auf Feststoffgehalt) eines Kieselgelfüllstoffs mit einer mittleren Korngröße von 3 µm zugesetzt wurden.

Diese Deckschicht dient bei photopolymerisierbaren Kopierschichten als Sauerstoffbarriere; bei positiv arbeitendem Material auf der Basis säurespaltbarer Verbindungen verbessert sie die Lagerstabilität und erweitert den Nacherwärmungsspielraum.

### Positiv arbeitendes Aufzeichnungsmaterial (Photoleiter)

Die Beschichtungslösung 1 aus

| | |
|---|---|
| 6,00 Gt | eines Styrol/Maleinsäureanhydrid-Copolymers (molares Verhältnis der Monomere 1,2:1), modifiziert durch Umsetzung mit Butanol (Säurezahl: 180; mittleres Molekulargewicht M_{w}: 150.000, bestimmt durch Gelpermeationschromatographie = GPC), |
| 4,00 Gt | 2,5-Bis-(4-diethylamino-phenyl)-[1,3,4]oxadiazol, |
| 0,01 Gt | Rhodamin FB (Color Index No. 45 170 ), |
| 0,01 Gt | Astrazonorange R (C.I. 48 040 ) und |
| 89,98 Gt | eines Gemisches aus Methylethylketon und Propylenglykol-monomethylether (65:55) |

wurde auf eine in Salpetersäure aufgerauhte und anschließend anodisierte Aluminiumfolie aufgetragen. Nach 3 min Trocknen bei 140 °C betrug das Schichtgewicht 6 g/m².

### Negativ arbeitendes Aufzeichnungsmaterial (Diazo)

Die Beschichtungslösung 2 aus

| | |
|---|---|
| 2,50 Gt | eines Methacrylsäure/Methyl-methacrylat/Glycerin-monomethacrylat-Terpolymers (20:30:50; mittleres Molekulargewicht M_{w}: 24.000, bestimmt durch GPC), |
| 0,50 Gt | eines Diazoniumsalz-Polykondensationsproduktes aus 1 mol 3-Methoxy-diphenylamin-4-diazoniumsulfat und 1 mol 4,4'-Bis-methoxymethyl-diphenylether, ausgefällt als Mesitylensulfonat, |
| 0,09 Gt | Victoriareinblau FGA (Basic Blue 81), |
| 0,07 Gt | Phenylphosphonsäure, |
| 0,10 Gt | eines Kieselgelfüllstoffs mit einer mittleren Korngröße von 3 µm und |
| 96,74 Gt | eines Gemisches aus Tetrahydrofuran und Ethylenglykolmonomethylether (40:60) |

wurde auf eine in Salzsäure aufgerauhte und anschließend anodisierte Aluminiumfolie aufgetragen. Nach 2 min Trocknen bei 100 °C betrug das Schichtgewicht 1,8 g/m².

### Negativ arbeitendes Aufzeichnungsmaterial (Photopolymer)

Die Beschichtungslösung 3 aus

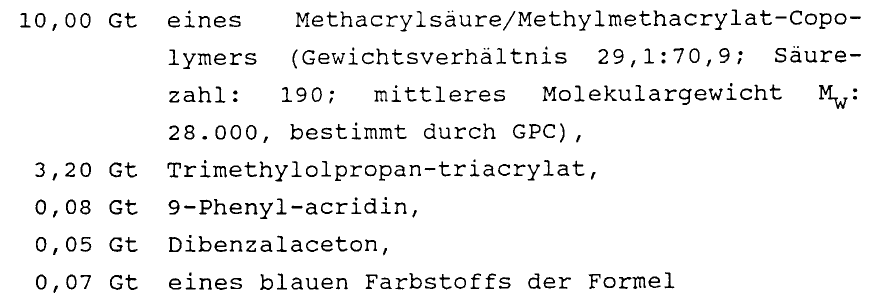

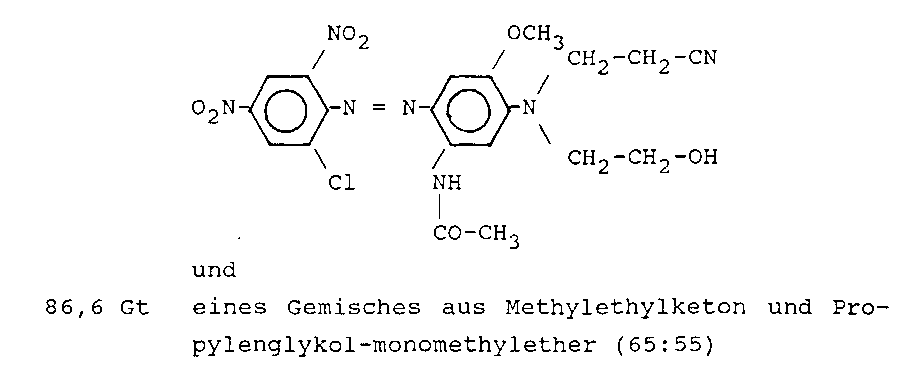

wurde auf eine naßgebürstete und anschließend anodiesierte Aluminiumfolie aufgetragen. Nach 2 min Trocknen bei 110 °C betrug das Schichtgewicht 2,5 g/m².

### Konvertierbares Aufzeichnungsmaterial (Diazo):

Die Beschichtungslösung 4 aus

| | |
|---|---|
| 8,50 Gt | eines m-Kresol/Formaldehyd-Novolaks (mittleres Molekulargewicht M_{w}: 6.000, bestimmt durch GPC), |
| 1,70 Gt | eines Esters aus 1 mol 2,3,4-Trihydroxy-benzophenon und 2,5 mol 1,2-Naphthochinon-2-diazid-4-sulfonylchlorid, |
| 0,06 Gt | 2,4-Bis-trichlormethyl-6-stilben-4-yl-[1,3,5]-triazin, |
| 0,07 Gt | Kristallviolett (C.I. 42 555), |
| 0,10 Gt | Kieselgelfüllstoff mit einer mittleren Korngröße von 3 µm und |
| 89,53 Gt | eines Gemisches aus Propylenglykol-monomethylether und Tetrahydrofuran (50:50) |

wurde auf eine in Salzsäure aufgerauhte und anschließend anodisierte Aluminiumfolie aufgetragen. Nach 2 min Trocknen bei 125 °C betrug das Schichtgewicht 2,0 g/m².

### Positiv arbeitendes Aufzeichnungsmaterial (Diazo)

Die Beschichtungslösung 5 aus

| | |
|---|---|
| 7,50 Gt | eines Polymeren aus (2-Hydroxyphenyl)methacrylat/Styrol-Copolymers (80:20; mittleres Molekulargewicht M_{w}: 18.000, bestimmt durch GPC), |
| 2,00 Gt | eines Esters aus 1 mol 2,3,4-Trihydroxy-benzophenon und 2,7 mol 1,2-Naphthochinon-2-diazid-5-sulfonylchlorid, |
| 0,25 Gt | 1,2-Naphthochinon-2-diazid-4-sulfonylchlorid |
| 0,40 Gt | 2,4-Dihydroxy-benzophenon, |
| 0,07 Gt | Kristallviolett (C.I. 42 555), |
| 0,20 Gt | Kieselgelfüllstoff mit einer mittleren Korngröße von 4 µm und |
| 89,58 Gt | eines Gemisches aus Methylethylketon und Propylenglykol-monomethylether (65:55) |

wurde auf eine naßgebürstete, zusätzlich in Salzsäure aufgerauhte und anschließend anodisiere Aluminiumfolie aufgetragen. Nach 2 min Trocknen bei 125 °C betrug das Schichtgewicht 2,4 g/m².

### Positiv arbeitendes Aufzeichnungsmaterial (mit säurespaltbarer Komponente)

Die Beschichtungslösung 6 aus

| | |
|---|---|
| 7,00 Gt | eines 4-Hydroxy-styrol/Methylmethacrylat-Copolymers (70:30; mittleres Molekulargewicht M_{w}: 20.000, bestimmt durch GPC), |
| 2,00 Gt | eines Kondensationsproduktes aus 2-Ethyl-butyraldehyd und Triethylenglykol (mittleres Molekulargewicht M_{w}: 2900, bestimmt durch GPC), |
| 0,11 Gt | 2,4-Bis-trichlormethyl-6-stilben-4-yl-[1,3,5]-triazin, |
| 0,40 Gt | Bis-(4-Hydroxy-phenyl)-sulfon, |
| 0,07 Gt | Kristallviolett (C.I. 42 555) und |
| 90,42 Gt | eines Gemisches aus Methylethylketon und Propylenglykol-monomethylether (65:55) |

wurde auf eine in Salzsäure aufgerauhte und anschließend anodisierte Aluminiumfolie aufgetragen. Nach 2 min Trocknen bei 125 °C betrug das Schichtgewicht 2,2 g/m².

### Beispiel 1

Das mit der Beschichtungslösung 1 hergestellte elektrophotographische Aufzeichnungsmaterial wurde im Dunkeln mit einer Corona auf -550 V aufgeladen und dann in Projektion mit 8 Halogenlampen von jeweils 500 Watt 15 s lang im Auflicht unter einer Positivpapiervorlage belichtet. Das entstandene latente Ladungsbild wurde dann mit Hilfe einer Magnetbürste mit einem Toner/Carrier-Gemisch (Toner auf der Basis eines Styrol/Butylacrylat-Copolymers mit einem Ladungssteuermittel auf Fettsäurebasis, angefärbt mit Ruß, mittlerer Teilchendurchmesser ca. 10 µm, Carrier auf Eisenbasis mit mittlerer Teilchengröße von ca. 100 µm, Mischungsverhältnis 2:98) betonert. Der schwarze Toner wurde hitzefixiert. Entschichtet wurde dann in einem Entschichtungsgerät mit einer Lösung gemäß Tabelle 1 bei 26 °C und einer Verarbeitungsgeschwindigkeit von 1,5 m/min (entsprechend ca. 15 s Einwirkzeit). Das entschichtete Aufzeichnungsmaterial wurde schließlich mit Wasser von 20° deutscher Härte (dH) im Umlauf gespült und mit einer handelsüblichen Gummierung (RC 795 der Hoechst AG) konserviert.

**Tabelle 1**

| Zusammensetzung | A Gew.-% | B* Gew.-% |
|---|---|---|
| Ethanolamin | 10,0 | 10,0 |
| Phenylpolyglykol | 10,0 | 10,0 |
| Dikaliumhydrogenphosphat | 2,0 | 2,0 |
| Trisethanolammoniumsalz des N,N-Bis-carboxymethyl-β-alanins | 1,0 | - |
| vollentsalztes Wasser | 77,0 | 78,0 |

Die Platten waren in beiden Fällen frei von Schleier, die Volltondeckung war gleichmäßig, das 34er Raster mit einer Flächendeckung von 8-95 % bei A und 10-95 % bei B wiedergegeben, Filmkanten, Halbtöne der Vorlage mit einer Schwarzdichte von <0,2 zeichneten nicht auf den Platten. Oxidschädigung war nicht erkennbar. Beim Entschichter A wurde nach der Verarbeitung von 1 m² Platte pro 100 ml Entschichter wurde nur eine geringe Verschmutzung der Wässerungsstation festgestellt. Dagegen verursachte der Entschichter B eine starke Verschmutzung aufgrund von Ausfällungen, die zum Teil den Nichtbildstellen der entschichteten Platten anhafteten und zu Druckstörungen führten.

### Beispiel 2

Mit der Beschichtungslösung 2 hergestellte negativ arbeitende Aufzeichnungsmaterialien wurden in einem Kontaktkopierrahmen durch eine Negativ-Filmvorlage unter einer 5-kW-Metallhalogenidlampe im Abstand von 110 cm 30 s lang belichtet und dann in einem Entwicklungsgerät bei 24 °C und einer Verarbeitungsgeschwindigkeit von 1,4 m/min (= 20 s Entwicklungszeit) entwickelt. Nach der Verarbeitung von 1 m² Platte pro Liter Entwickler wurden jeweils 20 ml nachdosiert, um die Entwicklermenge konstant zu halten. Die Entwickler wurden durch 1:1-Verdünnung der Konzentrate gemäß Tabelle 2 mit Wasser erhalten:

**Tabelle 2**

| Zusammensetzung | A* | B* | C* | D | E |
|---|---|---|---|---|---|
| | jeweils in Gew.-% | | | | |
| Kaliumpelargonat | 4 | 4 | 4 | 4 | 4 |
| Polyvinylpyrrolidon | 2 | 2 | 2 | 2 | 2 |
| Pentanatrium-triphosphat | 0 | 3 | 3 | 0 | 0 |
| Trinatriumsalz des N,N-Bis-carboxymethylisoserins | 0 | 0 | 0 | 5 | 5 |
| Phenoxyethanol | 5 | 5 | 5 | 5 | 5 |
| Dodecylbenzolsulfonat | 3 | 3 | 3 | 3 | 3 |
| KOH | 3 | 3 | 3 | 3 | 3 |
| Siliconentschäumer | 0,02 | 0,02 | 0,02 | 0,02 | 0,02 |
| vollentsalztes Wasser | ad 100 | | | | |

Die mit C und E bezeichneten Konzentrate unterscheiden sich von B und D nur durch eine zweiwöchige Lagerzeit bei 50 °C vor der Weiterverarbeitung.

Die entwickelten Platten waren bei Druckbeginn in allen Fällen frei von restschichtbedingtem Schleier, die Volltöne ohne Ausbrüche oder Abtrag wiedergegeben, das 60er Raster mit einer Flächendeckung von 2-98 % wiedergegeben, bei B bis E waren Halbtöne der Vorlage mit einer Schwarzdichte von <0,45 als Volltöne und solche mit einer Schwarzdichte >1,2 schichtfrei wiedergegeben, bei A waren Grauhalbtöne mit einer Schwarzdichte von <0,6 als Volltöne und solche mit einer Schwarzdichte >1,5 schichtfrei wiedergegeben, Oxidschädigung war nicht erkennbar.

Bei den Entwicklern B, D und E waren nach Verarbeitung von 1 m² Platte pro 50 ml Entwickler nur geringe Beläge auf Walzen und Bürsten im Entwicklungsgerät feststellbar, während bei Verwendung der Entwickler A und C eine starke Verschmutzung durch Ausfällungen resultierte. Weiterhin waren in diesen beiden Fällen die Halbtonkeile bei Testende um eine Dichtestufe voller wiedergegeben (Dichteinkremente 0,15).

Der Versuch zeigt die bessere Stabilität der im erfindungsgemäßen Verfahren verwendeten Entwicklerzusammensetzungen.

### Beispiel 3

Die mit der Beschichtungslösung 4 hergestellten konvertierbaren Aufzeichnungsmaterialien wurden in einem Kontaktkopierrahmen mit einer Negativfilmvorlage unter einer 5-kW-Metallhalogenidlampe im Abstand von 110 cm 50 s lang belichtet, in einem Durchlaufofen mit IR-Strahlung auf 145 C erhitzt, in einem Wasserbad abgekühlt, ganzflächig ohne Vorlage mit im UV-A-Bereich emittierenden Leuchtstofflampen ebenfalls im Durchlauf ausbelichtet und dann in einem Tauchbadentwicklungsgerät bei 24 °C und einer Verarbeitungsgeschwindigkeit von 1,0 m/min (= 20 s Entwicklungszeit) entwickelt. Die Entwickler wurden durch Auflösung der unten angegebenen Feststoffpulverkonzentrate in 20 l Leitungswasser der Härte 20 dH erhalten. Nach der Verarbeitung von 1 m² Platte pro Liter Entwickler wurden jeweils 20 ml Regenerat zudosiert. Die Regenerate wurden durch Auflösung der Feststoffkonzentrate in 10 1 Leitungswasser erhalten.

**Tabelle 3**

| Zusammensetzung | A* | B | C* |
|---|---|---|---|
| Tetranatriumsalz der Ethylendiamintetraessigsäure | 0 g | 0 g | 145 g |
| Tetranatriumsalz der N-(1,2-Dicarboxyethyl)-3-hydroxy-asparaginsäure | 0 g | 300 g | 0 g |
| Na₂SiO₃ x 5 H₂0 | 1800 g | 1800 g | 1800 g |

Die entwickelten Platten waren in allen Fällen frei von Schleier, die Volltöne ohne Ausbrüche oder sonstige Schädigungen durch Schichtabtrag wiedergegeben, das 60er Raster mit einer Flächendeckung von 2-98 % wiedergegeben, Halbtöne der Vorlage mit einer Schwarzdichte von <0,3 bei A und C, bei B von <0,45 als Volltöne und solche mit einer Schwarzdichte >1,35 schichtfrei wiedergegeben. Oxidschädigung war bei den im Entwickler C verarbeiteten Platten in Form weißer Aufhellungen auf der Plattenvorderseite und in Form eines weißen Belags in den-Randzonen der Plattenrückseite erkennbar.

Lediglich beim Entwickler B waren nach Verarbeitung von 1 m² Platte pro 100 ml Entwickler nur geringe Walzen- und Bürstenbelegung im Enwicklungsgerät sichtbar, während bei Verwendung von Entwickler A und C eine starke Verschmutzung gegeben war. Weiterhin waren Im Falle A und C die Nichtbildstellen der entwickelten Platten häufig durch adsorbierte Schmutzpartikel verunreinigt.

### Beispiel 4

Mit Aufzeichnungsmaterialien, die mit den Beschichtungslösungen 3 und 5 hergestellt waren, wurde eine Positiv-Negativ-Mischverarbeitung durchgeführt.

Die Aufzeichnungsmaterialien werden in einem Kontaktkopierrahmen durch eine Filmvorlage unter einer 6-kW-Metallhalogenidlampe im Abstand von 120 cm belichtet (positiv 50 s, negativ 30 s), beim negativ arbeitenden Material die Polyvinylalkohol-Deckschicht mit Wasser teilweise abgespült, und dann in einem Entwicklungsgerät bei 24 °C und einer Verarbeitungsgeschwindigkeit von 1,2 m/min ( = 20 s Entwicklungszeit) entwickelt. Nach Verarbeitung von 1 m² Platte pro Liter Entwickler wurden jeweils 20 ml Regenerat zudosiert. Die Entwickler werden durch 1:3-Verdünnung (1 Teil Konzentrat, 3 Teile Wasser) der folgenden Konzentrate erhalten:

**Tabelle 4**

| Zusammensetzung | A* | B* | C |
|---|---|---|---|
| | jeweils in Gew.-% | | |
| Kaliumdisilikat | 13,4 | 13,4 | 13,4 |
| Kaliumhydroxid | 7,0 | 7,0 | 7,0 |
| Trinatriumsalz der Nitrilotriessigsäure | 0 | 2,5 | 0 |
| Tetranatriumsalz der 2,2'-Iminodibernsteinsäure | 0 | 0 | 2,5 |
| Kaliumbenzoat | 0,5 | 0,5 | 0,5 |
| O,O'-Bis-carboxymethylpolyethylenglykol-600** | 0,5 | 0,5 | 0,5 |
| Siliconentschäumer | 0,01 | 0,01 | 0,01 |
| vollentsalztes Wasser | ad 100 | | |

| | | | |
|---|---|---|---|
| ** Polyethylenglykol-600 hat ein Molekulargewicht von 570 bis 630 und enthält durchschnittlich 12,5 bis 13,9 Ethylenglykol-Einheiten. | | | |

Die als Regenerate eingesetzten Lösungen waren bis auf den KOH-Gehalt, der 21,0 % betrug, identisch mit diesen Rezepturen, verdünnt wurde ebenfalls im Verhältnis 1:3.

Die entwickelten Platten waren in allen Fällen frei von Schleier, die Volltöne ohne Ausbrüche wiedergegeben, das 60er Raster mit einer Flächendeckung von 2-98 % bei der Positivplatte und 2-97 % bei der Negativplatte wiedergegeben, Grauhalbtöne mit einer Schwarzdichte von <0,45 waren bei den Positivplatten schichtfrei, bei den Negativplatten als Volltöne wiedergegeben.

Oxidschädigung zeigte sich mit den unter Beispiel 3 beschriebenen Erscheinungen bei Verwendung des Entwicklers B. Fladenbildung war in keinem Fall erkennbar.

Bei Entwickler C war nach Verarbeitung von 1 m² Platte pro 100 ml Entwickler nur eine leichte Belegung der Auslaufwalze des Enwicklungsgerätes festzustellen, die sich leicht entfernen ließ, während bei den Entwicklern A und B deutlich stärkere Beläge auftraten, im Falle B resultierend aus dem Oxidabbau.

### Beispiel 5

Mit Gemisch 6 hergestellte Aufzeichnungsmaterialien wurden in einem Kontaktkopierrahmen mit einer Negativ-filmvorlage unter einer 5-kW-Metallhalogenidlampe im Abstand von 110 cm 15 s lang bestrahlt, in einem Durchlaufofen mit IR-Strahlung auf 80 °C erhitzt, in einem Wasserbad abgekühlt und gleichzeitig die Deckschicht abgelöst, und dann in einem Tauchbadentwicklungsgerät bei 24 °C und einer Verarbeitungsgeschwindigkeit von 1,0 m/min (= 20 s Entwicklungszeit) entwickelt. Die Zusammensetzung der Entwickler ist unten angegeben. Nach Verarbeitung von 1 m² Platte pro Liter Entwickler wurde jeweils 20 ml Regenerat zudosiert. Die Regenerate wurden erhalten durch Zugabe von 0,7 mol Kaliumhydroxid auf 1 l des jeweiligen Entwicklers.

**Tabelle 5**

| Zusammensetzung | A* | B | C* |
|---|---|---|---|
| | in Gew.-% | | |
| Trinatrium-Salz des N,N-Bis-carboxymethyl-β-alanins | 0 | 0,4 | 0 |
| Lävulinsäure | 0 | 0 | 0,2 |
| Sr(OH)₂ x 8 H₂0 | 0,04 | 0,04 | 0,04 |
| Natriumtetraborat x 10 H₂O | 1,2 | 1,2 | 1,2 |
| Na₂SiO₃ x 9 H₂0 | 7,8 | 7,8 | 7,8 |
| vollentsalztes Wasser | ad 100 | | |

Alle Entwickler wurden vor Einsatz 2 Wochen bei 50 C gelagert. Danach wies der Entwickler A eine starke, der Entwickler C eine leichte Trübung auf, Entwickler B blieb klar.

Die entwickelten Platten waren in allen Fällen frei von Schleier, die Volltöne ohne Ausbrüche oder sonstige Schädigungen durch Schichtabtrag wiedergegeben, das 60er Raster mit einer Flächendeckung von 2-98 % wiedergegeben, Halbtöne der Vorlage mit einer Schwarzdichte von <0,45 waren schichtfrei und solche mit einer Schwarzdichte >1,20 bei B und >1,35 bei A und C als Vollton wiedergegeben.

Oxidschädigung war bedingt durch den Sr(OH)₂-Zusatz bei keinem der Entwickler zu beobachten.

Bei den Entwicklern A und C hatte sich nach Verarbeitung von 1 m² Platte pro 100 ml Entwickler ein Niederschlag gebildet, der sich am Boden des Enwicklungsgerätes sammelte, bei Entwickler B waren nur geringe Spuren eines Niederschlags zu bemerken. Durch Redeposits war insbesondere gegen Testende eine Vielzahl der in A und C verarbeiteten Platten verunreinigt nach der Entwicklung, so daß der im Druck punktuell auftretende Ton mit Plattenreiniger (RC 96 der Hoechst AG) auf den Platten entfernt werden mußte.

## Patentansprüche

1. Verfahren zum Entwickeln bestrahlter, strahlungsempfindlicher Aufzeichnungsmaterialien mit einem Entwickler, der mindestens eine in wäßriger Lösung alkalisch reagierende Verbindung enthält, dadurch gekennzeichnet, daß dem Entwickler mindestens eine Verbindung gemäß Formel I 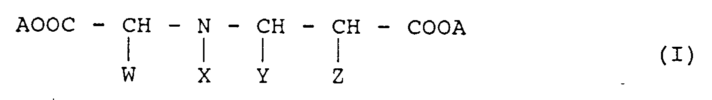 zugesetzt wird, worin
A H, Na, K, NH₄ oder NR₄ ist,
wobei R ein gegebenenfalls substituierter Alkyl-Rest ist,
W und X unabhängig voneinander H oder -CH₂-COOA sind,
Y H oder COOA und
Z H oder OH ist,
mit der Maßgabe, daß die Verbindung der Formel I mindestens 3 COOA-Einheiten aufweist.

2. Verfahren gemäß Anspruch 1, dadurch gekennzeichnet, daß die alkalisch reagierende Verbindung ein Amin, Hydroxid, Silikat, Phosphat, Borat oder Carbonat, bevorzugt ein Alkalisilikat, ist.

3. Verfahren gemäß Anspruch 1 oder 2, dadurch gekennzeichnet, daß der Anteil der alkalisch reagierenden Verbindung(en) 0,1 bis 20 Gew.-%, bevorzugt 0,5 bis 10 Gew.-%, jeweils bezogen auf das Gesamtgewicht des gebrauchsfertigen Entwicklers, beträgt.

4. Verfahren gemäß einem oder mehreren der Ansprüche 1 bis 3, dadurch gekennzeichnet, daß in den Verbindungen der Formel I A = H oder Na ist.

5. Verfahren gemäß einem oder mehreren der Ansprüche 1 bis 4, dadurch gekennzeichnet, daß W = Y = H ist, wenn X = CH₂-COOA ist, und W = CH₂-COOA und Y = COOA sind, wenn X = H ist.

6. Verfahren gemäß einem oder mehreren der Ansprüche 1 bis 5, dadurch gekennzeichnet, daß der Anteil der Verbindung(en) der Formel I 0,01 bis 5 Gew.-%, bevorzugt 0,1 bis 5 Gew.-%, jeweils bezogen auf das Gesamtgewicht des gebrauchsfertigen Entwicklers, beträgt.

7. Verfahren gemäß einem oder mehreren der Ansprüche 1 bis 5, dadurch gekennzeichnet, daß der Entwickler zusätzlich ein organisches Lösemittel, ein anionisches, kationisches, zwitterionisches oder nichtionisches Tensid, einen Korrosionsinhibitor, eine hydrotrope Verbindung, ein O-Carboxymethyl- oder O,O'-Bis-carboxymethyl-polyethylenglykol mit 2 bis 500 Ethylenglykoleinheiten und/oder ein Antischaummittel enthält.

8. Verfahren gemäß einem oder mehreren der Ansprüche 1 bis 7, dadurch gekennzeichnet, daß die Aufzeichnungsmaterialien bei 18 bis 50 °C, bevorzugt 20 bis 40 °C, 5 s bis 1 min lang entwickelt werden.

9. Entwickler zum Entwickeln bestrahlter, strahlungsempfindlicher Aufzeichnungsmaterialien, im wesentlichen bestehend aus Wasser, mindestens einer Verbindung der Formel I (siehe Anspruch 1), mindestens einer alkalischen Verbindung sowie gegebenenfalls organischen Lösemitteln, die mit Wasser mischbar ist, Tensiden, Korrosionsinhibitoren, O-Carboxymethyl- oder O,O'-Bis-carboxymethyl-polyethylenglykol mit 2 bis 500 Ethylenglykoleinheiten oder Antischaummitteln.

10. Entwickler gemäß Anspruch 9, dadurch gekennzeichnet, daß die Verbindung der Formel I N,N-Bis-carboxymethyl-β-alanin, N,N-Bis-carboxymethyl-isoserin, N-(1,2-Dicarboxy-ethyl)-3-hydroxy-asparaginsäure, 2,2'-Iminodibernsteinsäure oder das Natrium-, Kalium-, Ammonium- oder quaternäre Ammoniumsalz davon ist.

11. Entwickler gemäß Anspruch 9, dadurch gekennzeichnet, daß der Anteil der Verbindung(en) der Formel I 0,01 bis 5 Gew.-% , bevorzugt 0,1 bis 5 Gew.-%, bezogen auf das Gesamtgewicht des Entwicklers, beträgt.

12. Entwickler gemäß Anspruch 9, dadurch gekennzeichnet, daß der Anteil der alkalischen Verbindung(en) 0,1 bis 20 Gew.-%, bevorzugt 0,5 bis 10 Gew.-%, bezogen auf das Gesamtgewicht des Entwicklers, beträgt.

## Claims

1. Process for developing irradiated, radiation-sensitive recording materials with a developer which contains at least one compound which is alkaline-reacting in aqueous solution, characterised in that at least one compound of the formula I 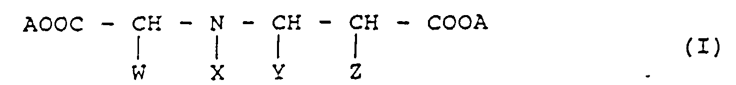 is added to the developer, in which formula
A is H, Na, K, NH₄ or NR₄,
wherein R is an optionally substituted alkyl residue,
W and X are mutually independently H or -CH₂-COOA,
Y is H or COOA and
Z in H or OH,
providing that the compound of the formula I has at least 3 COOA units.

2. Process according to claim 1, characterised in that the alkaline-reacting compound is an amine, hydroxide, silicate, phosphate, borate or carbonate, preferably an alkali metal silicate.

3. Process according to claim 1 or 2, characterised in that the proportion of the alkaline-reacting compound(s) is 0.1 to 20 wt.%, preferably 0.5 to 10 wt.%, in each case relative to the total weight of the ready-to-use developer.

4. Process according to one of more of claims 1 to 3, characterised in that, in the compounds of the formula I, A = H or Na.

5. Process according to one or more of claims 1 to 4, characterised in that W = Y = H, if X = CH₂-COOA, and W = CH₂-COOA and Y = COOA, if X = H.

6. Process according to one or more of claims 1 to 5, characterised in that the proportion of the compound(s) of the formula I is 0.01 to 5 wt.%, preferably 0.1 to 5 wt.%, in each case relative to the total weight of the ready-to-use developer.

7. Process according to one or more of claims 1 to 5, characterised in that the developer additionally contains an organic solvent, an anionic, cationic, zwitterionic or nonionic surfactant, a corrosion inhibitor, a hydrotropic compound, an O-carboxymethyl or O,O'-bis-carboxymethyl polyethylene glycol having 2 to 500 ethylene glycol units and/or an antifoaming agent.

8. Process according to one or more of claims 1 to 7, characterised in that the recording materials are developed at 18 to 50°C, preferably 20 to 40°C, for 5 seconds to 1 minute.

9. Developer for developing irradiated, radiation-sensitive recording materials which substantially consists of water, at least one compound of the formula I (see claim 1), at least one alkaline compound optionally together with organic solvents, which are miscible with water, surfactants, corrosion inhibitors, O-carboxymethyl or O,O'-bis-carboxymethyl polyethylene glycol having 2 to 500 ethylene glycol units or antifoaming agents.

10. Developer according to claim 9, characterised in that the compound of the formula I is N,N-bis-carboxymethyl-β-alanine, N,N-bis-carboxymethylisoserine, N-(1,2-dicarboxyethyl)-3-hydroxyaspartic acid, 2,2'-iminodisuccinic acid or the sodium, potassium, ammonium or quaternary ammonium salt thereof.

11. Developer according to claim 9, characterised in that the proportion of the compound(s) of the formula I is 0.01 to 5 wt.%, preferably 0.1 to 5 wt.%, relative to the total weight of the developer.

12. Developer according to claim 9, characterised in that the proportion of the alkaline compound(s) is 0.1 to 20 wt.%, preferably 0.5 to 10 wt.%, relative to the total weight of the developer.

## Revendications

1. Procédé pour le développement de matériaux d'enregistrement sensibles aux rayonnements, irradiés, avec un révélateur qui contient au moins un composé réagissant de manière alcaline dans une solution aqueuse, caractérisé en ce que l'on ajoute au révélateur au moins un composé selon la formule I 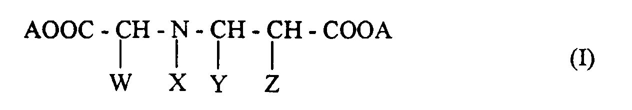 où
A est H, Na, K, NH₄ ou NR₄,
R étant un reste alkyle éventuellement substitué,
W et X sont indépendamment H ou -CH₂-COOA,
Y est H ou COOA et
Z est H ou OH,
à la condition que le composé de la formule I présente au moins 3 unités COOA.

2. Procédé selon la revendication 1, caractérisé en ce que le composé réagissant de manière alcaline est une amine, un hydroxyde, un silicate, un phosphate, un borate ou un carbonate, de préférence un silicate d'alcali.

3. Procédé selon la revendication 1 ou 2, caractérisé en ce que la part du(des) composé(s) réagissant de manière alcaline est de 0,1 à 20 % en poids, de préférence de 0,5 à 10 % en poids, rapportés à chaque fois au poids total du révélateur prêt à l'utilisation.

4. Procédé selon l'une ou plusieurs quelconques des revendications 1 à 3, caractérisé en ce que dans les composés de la formule I A = H ou Na.

5. Procédé selon l'une ou plusieurs quelconques des revendications 1 à 4, caractérisé en ce que W = Y = H lorsque X = CH₂-COOA et W = CH₂-COOA et Y = COOA lorsque X = H.

6. Procédé selon l'une ou plusieurs quelconques des revendications 1 à 5, caractérisé en ce que la part du(des) composé(s) de la formule I est de 0,01 à 5 % en poids, de préférence de 0,1 à 5 % en poids, rapportés à chaque fois au poids total du révélateur prêt à l'utilisation.

7. Procédé selon l'une ou plusieurs quelconques des revendications 1 à 5, caractérisé en ce que le révélateur contient en outre un solvant organique, un dérivé tensioactif anionique, cationique, amphotère ou non ionique, un inhibiteur de corrosion, un composé hydrotrope, un o-carboxyméthyl- ou o,o'-bis-carboxyméthyl-polyéthylèneglycol avec de 2 à 500 unités éthylèneglycol et/ou un agent antimoussant.

8. Procédé selon l'une ou plusieurs quelconques des revendications 1 à 7, caractérisé en ce que les matériaux d'enregistrement sont développés à une température de 18 à 50°C, de préférence de 20 à 40°C pendant de 5 s à 1 min.

9. Révélateur pour le développement de matériaux d'enregistrement sensibles aux rayonnements, irradiés, essentiellement constitué d'eau, d'au moins un composé de la formule I (voir revendication 1), d'au moins un composé alcalin ainsi qu'éventuellement d'un solvant organique qui est miscible à l'eau, d'un dérivé tensioactif, d'un inhibiteur de corrosion, d'o-carboxyméthyl- ou d'o,o'-bis-carboxyméthyl-polyéthylèneglycol avec de 2 à 500 unités éthylèneglycol ou d'un agent antimoussant.

10. Révélateur selon la revendication 9, caractérisé en ce que le composé de la formule I est la N,N-bis-carboxyméthyl-β-alanine, la N,N-bis-carboxyméthylisosérine, l'acide N-(1,2-dicarboxyéthyl)-3-hydroxyaspartique, l'acide 2,2'-iminodisuccinique ou le sel de sodium, de potassium, d'ammonium ou d'ammonium quatemaire de ceux-ci.

11. Révélateur selon la revendication 9, caractérisé en ce que la part du(des) composé(s) de la formule I est de 0,01 à 5 % en poids, de préférence de 0,1 à 5 % en poids, rapportés au poids total du révélateur.

12. Révélateur selon la revendication 9, caractérisé en ce que la part du(des) composé(s) alcalin(s) est de 0,1 à 20 % en poids, de préférence de 0,5 à 10 % en poids, rapportés au poids total du révélateur.
